# EUROPEAN PATENT SPECIFICATION

(11) **EP 0 478 313 B1**
(45) Date of publication and mention of the grant of the patent: **21.08.1996**
(21) Application number: 91308756.5
(22) Date of filing: 25.09.1991
(51) Int. Cl.: H05K 3/46, H05K 1/00

(54) **A multilayer printed circuit board and manufacturing method therefor**
Mehrschichtige Leiterplatte und Verfahren zu ihrer Herstellung
Plaquette multicouche à circuit imprimé et méthode de sa production

(30) Priority: 27.09.1990 JP 255464/90
(43) Date of publication of application: 01.04.1992
(73) Proprietor: International Business Machines Corporation, Armonk, N.Y. 10504 (US)
(72) Inventor: Tsukada, Yutaka, Kouga-gun, Shiga-ken (JP); Tsuchida, Shuhei, Kusatsu-shi, Shiga-ken (JP)
(74) Representative: Burt, Roger James, Dr.

(56) References cited:
- DE-A- 2 202 077
- DE-A- 3 840 207
- US-A- 4 830 691

## Description

This invention relates to multilayer printed circuit boards and manufacturing methods therefor.

In conventional multilayer printed circuit boards, it is common to position power supply and ground layers inside the board and signal layers on the outside, and to interconnect those layers by throughholes.

US-A-4,830,691 discloses a multilayer circuit board in which a combination of conductive vias and throughholes are used. The multilayer wiring structure, including vias, is produced, and is then integrally laminated to a substrate. Thereafter additional workings, such as drilling of throughholes, can be performed on the resulting structure. This document does not discuss the issue of when to use throughholes and when to use vias.

In as much as the throughholes are formed by mechanical drilling and hence tend to be of relatively large size, it is difficult to increase the wiring density of the circuit board. Also, inasmuch as it is necessary to design the signal layers on both sides while always taking throughhole connections into consideration, freedom in wiring design is relatively restricted. Moreover, since the throughholes pass through the power supply and ground layers, it is necessary to provide clearance holes at those throughhole locations in the power supply and ground layers where no power supply or ground connections are required. Accordingly, the higher the throughhole density becomes, the smaller the clearance holes have to be formed with still higher accuracy, which in turn entails more accurate alignment of the signal layers with the power supply and ground layers in laminating those layers. Recently, in addition to PIH (Pin In Hole) components which are mounted by inserting their pins into throughholes, SMT (Surface Mount Technology) components which are mounted without pins have come to be used. Therefore, there is a need for multilayer printed circuit boards which can be applied to both SMT and PIH components.

An object of the present invention is to provide a multilayer printed circuit board which allows higher wiring density and higher degree of freedom in design of wiring and enables throughhole connections to be minimized.

In the first aspect of the present invention, there is provided a multilayer printed circuit board comprising: an insulating substrate; a conductive layer provided on one side of said substrate; a laminate provided on the other side of said substrate, said laminate comprising wiring layers and at least one insulating layer; a conductive through hole extending through said substrate and said laminate; each of said wiring layers including signal wiring conductors which are interconnected by conductive vias in said at least one insulating layer; said conductive layer including a power supply conductor, and the outermost wiring layer of said laminate includes signal wiring conductors and a power supply conductor; and the power supply conductors in said conductive layer and said outermost wiring layer being interconnected by said conductive through hole; whereby the conductive vias are used for interconnection of the signal wiring conductors in the wiring layers and the conductive through hole is used for a power connection.

In preferred embodiments one side of the double-sided copper clad circuit board is used to mount components and supply a ground potential, and the other side is used to supply a power supply voltage.

Viewed from a second aspect, the present invention provides a multilayer printed circuit board comprising: an insulating substrate; a laminate provided on each side of said substrate, each said laminate comprising wiring layers and at least one insulating layer; a conductive through hole extending through said substrate and said laminates; each of said wiring layers including signal wiring conductors which are interconnected by conductive vias in said at least one insulating layer; the outermost wiring layer of each said laminate including signal wiring conductors and power supply conductors; and the power supply conductors in said outermost wiring layers of said laminates being interconnected by said conductive through hole; whereby the conductive vias are used for interconnection of the signal wiring conductors in the wiring layers and the conductive through hole is used for a power connection.

This arrangement permits one side of the circuit board to be used to mount components and feed a ground potential, whilst the other side is used to mount components and to feed a power supply voltage.

The present invention will be described further, by way of example only, with reference to an embodiment thereof as illustrated in the accompanying drawings, in which:
Figures 1A to 1J show the manufacturing process of a multilayer printed circuit board according to a first embodiment of the present invention; and
Figures 2A to 2I show the manufacturing process of a multilayer printed circuit board according a second embodiment of the present invention.

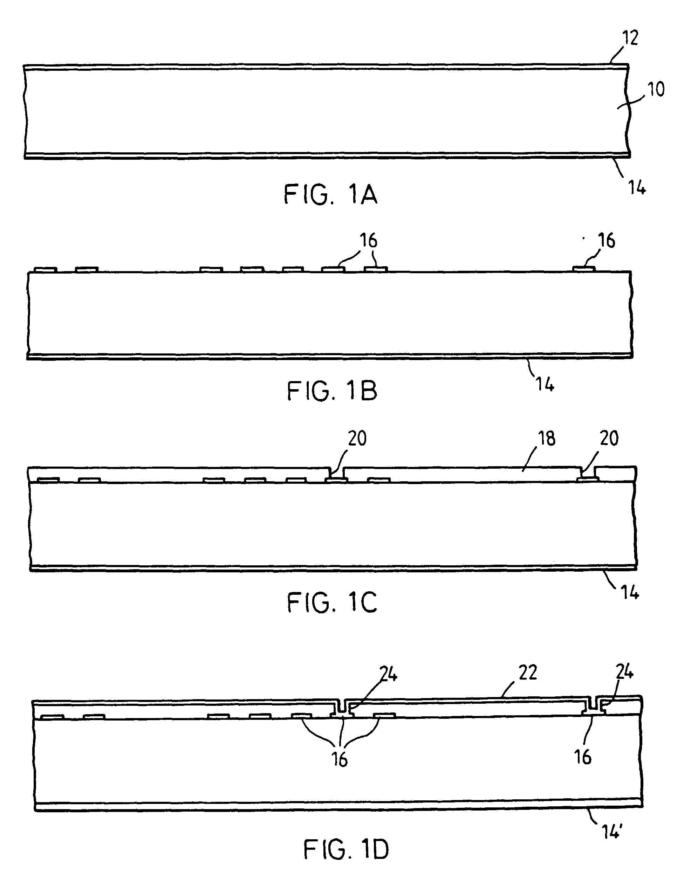

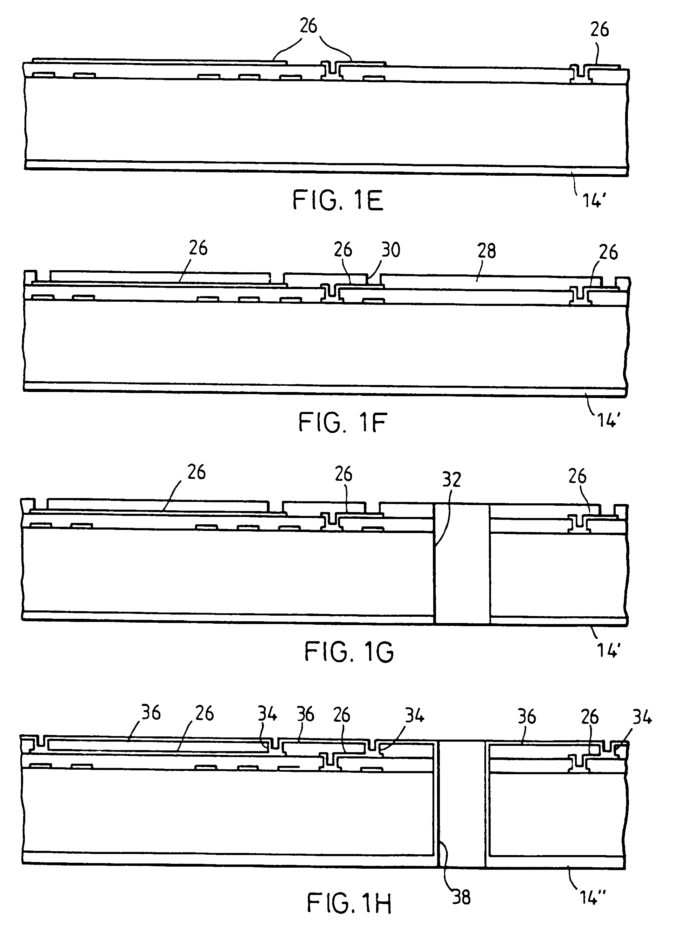

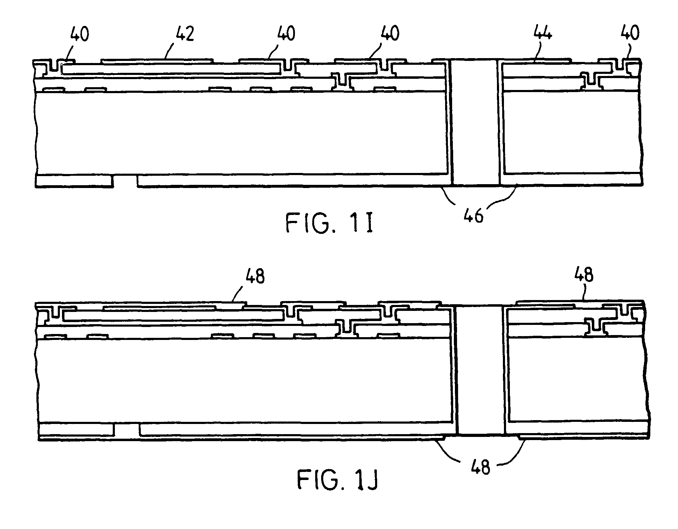

Figure 1 shows the steps involved in the manufacturing process of a multilayer printed circuit board in accordance with an embodiment of the present invention. In this embodiment a four-layer printed circuit board is manufactured.

Referring now to Figure 1A, there is shown a glass epoxy insulating substrate 10 laminated on both sides with copper layers 12 and 14. The copper layers are each 18 microns thick.

As shown in Figure 1B, the copper layer 12 is then patterned by a conventional selective etching technique to form a first wiring layer or wiring level which includes signal wiring conductors 16. The copper layer 14 on the other side is used as a power supply layer in this embodiment.

Next, as shown in Figure 1C, a photosensitive resin insulating layer 18 is applied to cover the signal wiring conductors 16 in the first wiring layer, and is then exposed and developed to form viaholes 20 at selected locations. The photosensitive resin insulating layer used is, in preferred embodiments, Probimer 52, a negative type photosensitive epoxy resin placed on the market by Ciba-Geigy Ltd. This epoxy resin is applied to the surface of the substrate by curtain coating, precured at 80°C for one hour, exposed with a mercury lamp, and then developed with developer DY90 (a mixture of propylene carbonate, cyclohexanone, and gamma-butyrolactone) of Ciba-Geigy Ltd.

Next, the surface of the epoxy resin layer 18 is roughened by etching with a solution of potassium permanganate, and then activated with Activator 180, a seeding chemical of DYNACHEM Inc. This seeding chemical is a solution including colloidal tin and palladium.

As shown in Figure 1D, a further copper layer 22 is then deposited by electroless plating on the entire surface of the insulating layer 18 formed with viaholes. This copper layer 22 is connected to the signal wiring conductors 16 of the first level by plated viaholes 24. The copper deposited by the electroless plating is also deposited on the lower copper layer 14 in Figure 1C and thus thickens the copper layer 14 a little. The lower copper layer thus thickened is indicated by reference number 14′ in Figure 1D. The copper layer may be further thickened by electroplating after the electroless plating, if necessary.

In Figure 1E, the copper layer 22 is patterned by selective etching to form a second wiring layer or wiring level which includes signal wiring conductors 26.

As shown in Figure 1F, in the same manner as the step shown in Figure 1C, a second photosensitive resin insulating layer 28 is applied on the signal wiring conductors 26 in the second level, and viaholes 30 are formed at selected locations by exposure and development.

Next, a throughhole 32, as shown in figure 1G, is formed by mechanical drilling at a location where a power supply connection is to be established. Although only one throughhole 32 is shown in Figure 1G, a plurality of throughholes may be provided as required. The throughhole 32 is used to provide a power supply connection from the power supply layer on the lower side of the circuit board to a power supply conductor or power supply pad on the upper side of the circuit board.

As shown in Figure 1H, in the same manner as the step shown in Figure 1D, copper is deposited by electroless plating on the entire surface including the walls of the throughhole 32. The copper is also deposited on the lower copper layer 14′ shown in Figure 1G and thus thickens the lower copper layer 14′. The lower copper layer thus thickened is indicated by reference number 14˝ in Figure 1H. If necessary, the deposited copper layer may be further thickened by electroplating after the electroless plating. On the upper surface of the circuit board, there now exists a surface conductor layer 36, which is connected through the vias 34 to the signal wiring conductors 26 in the second level. A throughhole connection 38 is formed in the throughhole 32, which connects the upper surface and the lower surface of the circuit board.

In the next step, as shown in Figure 1I, the surface conductor layer 36 and the lower copper layer 14˝ are patterned by selective etching to form signal wiring conductors 40 of a third wiring level, a ground conductor 42 on the upper surface, a power supply conductor or power supply land 44 on the upper surface, and a power supply conductor 46 on the lower surface. The signal wiring conductors 40 on the upper surface provide SMT component mounting terminals. The lower copper layer 14˝ in Figure 1H may be patterned as necessary when such components as resistors and capacitors are to be mounted on the lower side of the substrate for supply voltage regulation, decoupling and so on.

Finally, as shown in Figure 1J, the conductor areas not to be exposed are covered with solder resist layers 48 of a polyamide or epoxy resin.

In the above-mentioned embodiment, the copper layer 14 on the lower surface of the insulating substrate is used as a power supply layer. However, the copper layer 14 may be used as a ground layer and the copper layer 42 on the upper surface of the circuit board may be used as a power supply layer. The electrical characteristics are almost the same in both cases.

Although a four-layer printed circuit board has been illustrated in the above, it is also possible to manufacture a printed circuit board having more wiring layers by repeating similar steps.

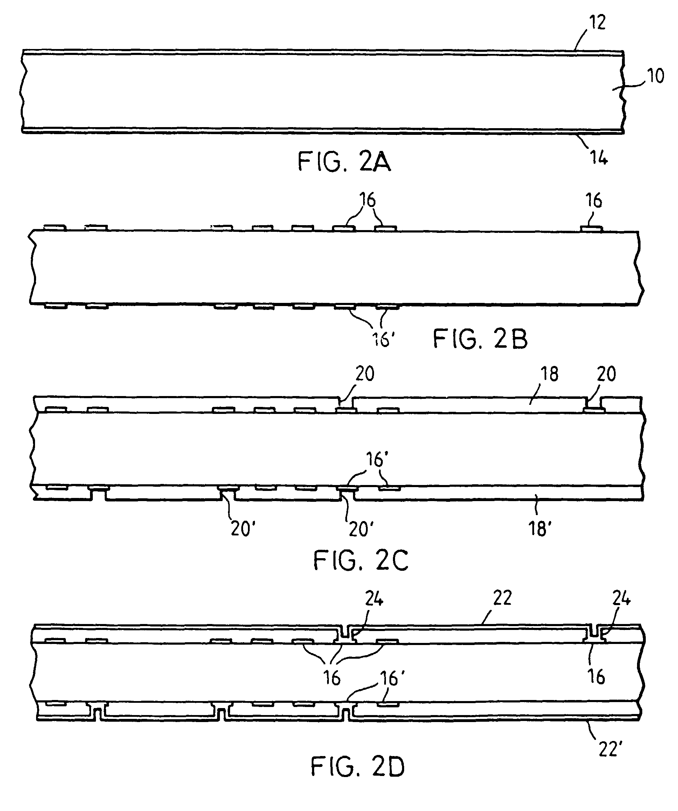

Figures 2A to 2I show the steps involved in the manufacturing process of a multilayer printed circuit board in accordance with a second embodiment of the present invention such that wiring layers are stacked on both sides of an insulating substrate. The manufacturing process is basically the same as that shown in Figures 1A to 1I, except that wiring layers are formed on the lower side of the substrate 10 as well. The elements on the lower side of the substrate corresponding to those formed on the upper side of the substrate are designated by like reference numbers but with primes attached.

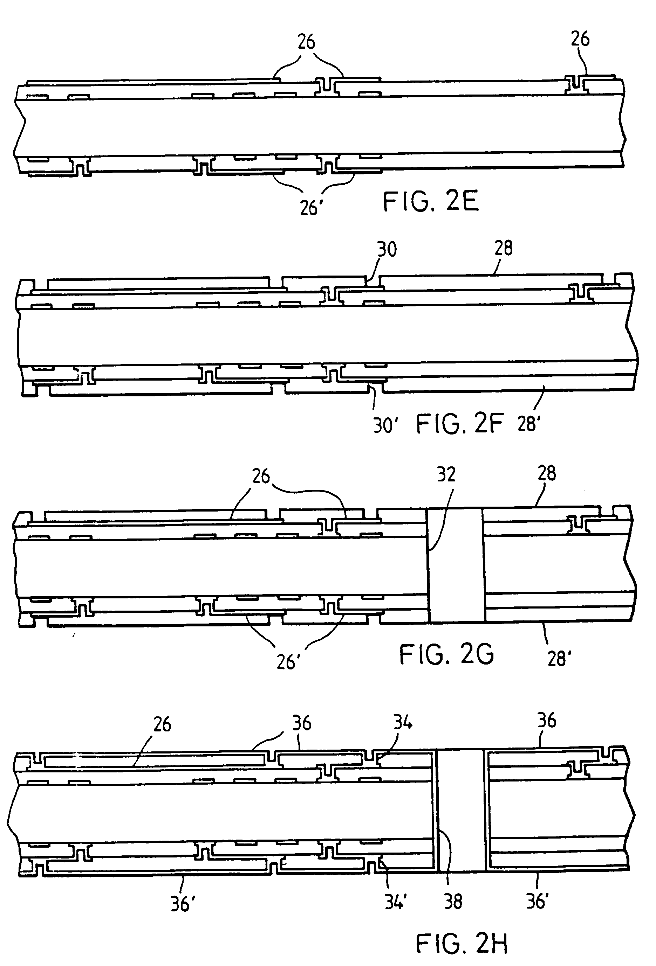

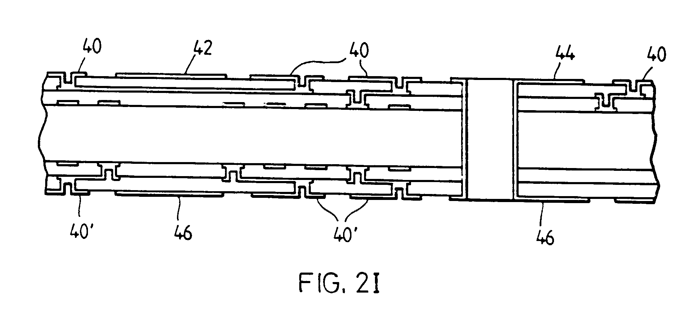

With regard to Figure 2, both the upper copper layer 12 and the lower copper layer 14 are patterned as shown in Figure 2B and are used as signal wiring layers. The subsequent steps are similar to those described with regard to Figures 1C to 1I. A throughhole 32 is formed as shown in Figure 2G. The entire surface is then deposited with copper by electroless plating as shown in Figure 2H. As shown in Figure 2I, the surface conductor layers 36 and 36′ are etched to desired patterns. On the upper side of the circuit board there are formed a power supply conductor or power supply land 44 connected to a lower power supply layer 46 through a plated throughhole 38, signal wiring conductors 40 and a ground layer 42. Also, a power supply layer 46 and signal wiring conductors 40′ are formed on the lower side of the circuit board. The signal wiring conductors 40 and 40′ may be used as SMT component mounting terminals.

If desired the conductor layer 42 may be used as a power supply layer and the conductor layer 46 may be used as a ground layer.

The circuit board shown in Figure 2I has no ground layer on its lower side. Hence, when a component which requires a ground connection is mounted on the lower side of the circuit board, it is sufficient to provide on the lower side of the circuit board a ground land (not illustrated) similar to the power supply land 44, and to provide another throughhole through which to connect the ground layer 42 on the upper side of the circuit board to the ground land on the lower side. Needless to say, the ground land may be formed by the patterning used in Figure 2I at the same time as the other conductor patterns on the surfaces of the circuit board.

The preferred embodiment of the present invention has the following advantages:
(a) Since interconnection between signal layers is made through small viaholes formed by photoprocessing and the use of larger throughholes is minimized, the signal wiring density of the four-layer printed circuit board shown in Figure 1 can be increased to about twice that of conventional four-layer printed circuit boards of the throughhole connection type, with the result that circuit package size can be greatly reduced;
(b) Since throughhole connections for signal wiring conductors are reduced, parasitic inductances and capacitances of signal wires are notably decreased, and hence the performance of a multilayer printed circuit board in accordance with the present invention is better than that of conventional circuit boards;
(c) Since signal wiring can be designed substantially without regard to throughhole connections, the degree of freedom for signal wiring design is increased such that designs are facilitated easier and wiring design time can be shortened.
(d) Since the surface regions of a printed circuit board with no signal wiring conductors formed are covered with a power supply layer or ground layer, a higher shielding effect can be obtained.
(e) The described embodiment can be very economically implemented by utilizing existing processes and materials.
(f) The described embodiment can be applied not only to SMT component mounting but also to PIH component mounting.

## Claims

1. A multilayer printed circuit board comprising:
an insulating substrate (10);
a conductive layer (14) provided on one side of said substrate;
a laminate provided on the other side of said substrate, said laminate comprising wiring layers (12, 22, 36) and at least one insulating layer (18);
a conductive through hole (32) extending through said substrate (10) and said laminate;
each of said wiring layers (12, 22, 36) including signal wiring conductors (16, 26, 40) which are interconnected by conductive vias (24, 34) in said at least one insulating layer;
said conductive layer (14) including a power supply conductor (46), and the outermost wiring layer (36) of said laminate includes signal wiring conductors (40) and a power supply conductor (44); and
the power supply conductors (46, 44) in said conductive layer (14) and said outermost wiring layer (36) being interconnected by said conductive through hole (32);
whereby the conductive vias are used for interconnection of the signal wiring conductors in the wiring layers and the conductive through hole is used for a power connection.

2. A multilayer printed circuit board comprising:
an insulating substrate (10);
a laminate provided on each side of said substrate, each said laminate comprising wiring layers and at least one insulating layer;
a conductive through hole (32) extending through said substrate and said laminates;
each of said wiring layers (12, 22, 36) including signal wiring conductors (16, 26, 40) which are interconnected by conductive vias (24, 34) in said at least one insulating layer;
the outermost wiring layer of each said laminate including signal wiring conductors (40, 40') and power supply conductors (44, 46); and
the power supply conductors in said outermost wiring layers of said laminates being interconnected by said conductive through hole;
whereby the conductive vias are used for interconnection of the signal wiring conductors in the wiring layers and the conductive through hole is used for a power connection.

3. A multilayer printed circuit board as claimed in claim 1 or claim 2 wherein said insulating substrate (10) is a glass - epoxy substrate.

4. A multilayer printed circuit board as claimed in any preceding claim, wherein said signal wiring conductors (40) in said outermost wiring layer (36) are patterned to provide terminals for attachment of surface mount components.

5. A multilayer printed circuit board as claimed in any preceding claim, wherein said outermost wiring layer (36) further includes a ground conductor (42).

6. A method of manufacturing a multilayer printed circuit board as claimed in any of claims 1, 3, 4 or 5, comprising the steps of:
(a) preparing the insulating substrate (10) with both surfaces being clad with copper;
(b) patterning the copper layer (12) on one side of said substrate to form a wiring layer including signal wiring conductors (16);
(c) depositing an insulating layer (18) on said wiring layer;
(d) forming vias (20) in said insulating layer (18) to expose selected portions of said signal wiring conductors (16);
(e) depositing a copper layer (22) on said insulating layer, including said vias;
(f) patterning the deposited copper layer (22) to form a wiring layer including signal wiring conductors (26);
(g) repeating said steps (c) - (f), as required;
(h) depositing an insulating layer (28) on the top wiring layer;
(i) forming vias in the insulating layer (28) formed in step (h) to expose selected portions of the signal wiring conductors (26) in said top wiring layer;
(j) forming the through hole (32) at a selected location of the resulting structure;
(k) depositing a copper layer (36) on the entire surface of said structure, including said through hole (32); and
(l) patterning the deposited copper layer (36) to form, on the insulating layer formed in step (h), the outermost wiring layer including the signal wiring conductors (40) and the power supply conductor (44) and, on the other side of said substrate, the conductive layer (14) including the power supply conductor (46), said power supply conductors (44, 46) in said outermost wiring layer and said conductive layer being interconnected by said through hole (32).

7. A method of manufacturing a multilayer printed circuit board as claimed in any of claims 2 to 5, comprising the steps of:
(a) preparing the insulating substrate (10) with both surfaces being clad with copper;
(b) patterning the copper layers (12, 14) on both sides of said substrate to form wiring layers including signal wiring conductors (16, 16');
(c) depositing an insulating layer (18, 18') on each of said wiring layers;
(d) forming vias (20, 20') in said insulating layers to expose selected portions of said signal wiring conductors in said wiring layers;
(e) depositing a copper layer (22, 22') on each of said insulating layers, including said vias;
(f) patterning the deposited copper layers (22, 22') to form wiring layers including signal wiring conductors (26, 26');
(g) repeating said steps (c) - (f), as required;
(h) depositing an insulating layer (28, 28') on each of the top wiring layers;
(i) forming vias in the insulating layers formed in step (h) to expose selected portions of the signal wiring conductors (26, 26') in said top wiring layers;
(j) forming the through hole (32) at a selected location of the resulting structure;
(k) depositing a copper layer (36, 36') on the entire surface of said structure, including said through hole (32); and
(l) patterning the deposited copper layer (36) to form, on each side of said substrate, the outermost wiring layer including the signal wiring conductors (40, 40') and the power supply conductors (44, 46), said power supply conductors in said outermost wiring layers being interconnected by said through hole (32).

8. A method as claimed in claim 6 or claim 7, wherein said insulating layers are formed out of a photosensitive resin and said vias are formed by exposing and developing the photosensitive layers.

9. A method as claimed in any of claims 6 to 8, wherein the deposition of said copper layers are performed by electroless plating.

## Patentansprüche

1. Mehrschichtige Leiterplatte umfassend:
ein isolierendes Substrat (10);
eine leitende Schicht (14), die auf einer Seite des Substrats bereitgestellt wird;
ein Laminat, das auf der anderen Seite des Substrats bereitgestellt wird, wobei das Laminat Verdrahtungsschichten (12, 22, 36) und mindestens eine isolierende Schicht (18) umfaßt;
ein leitendes Durchgangsloch (32), das sich durch das Substrat (10) und das Laminat erstreckt;
wobei jede der Verdrahtungsschichten (12, 22, 36) Signalverdrahtungsleitungen (16, 26, 40) einschließt, die durch leitende Durchkontakte (24, 34) in der mindestens einen isolierenden Schicht verbunden sind;
wobei die leitende Schicht (14) eine Leistungsversorgungsleitung (46) einschließt, und die äußerste Verdrahtungsschicht (36) des Laminats Signalverdrahtungsleitungen (40) und eine Leistungsversorgungsleitung (44) einschließt; und
die Leistungsversorgungsleitungen (46, 44) in der leitenden Schicht (14) und die äußerste Verdrahtungsschicht (36) durch das leitende Durchgangsloch (32) verbunden sind;
wobei die leitenden Durchkontakte für eine Zwischenverbindung der Signalverdrahtungsleitungen in den Verdrahtungsschichten verwendet werden und das leitende Durchgangsloch für eine Leistungsverbindung verwendet wird.

2. Mehrschichtige Leiterplatte umfassend:
ein isolierendes Substrat (10);
ein Laminat, das auf jeder Seite des Substrats bereitgestellt wird, wobei jedes Laminat Verdrahtungsschichten und mindestens eine isolierende Schicht umfaßt;
ein leitendes Durchgangsloch (32), das sich durch das Substrat und die Laminate erstreckt;
wobei jede der Verdrahtungsschichten (12, 22, 36) Signalverdrahtungsleitungen (16, 26, 40) einschließt, die durch leitende Durchkontakte (24, 34) in der mindestens einen isolierenden Schicht verbunden sind;
die äußerste Verdrahtungsschicht jedes Laminats Signalverdrahtungsleitungen (40, 40') und Leistungsversorgungsleitungen (44, 46) einschließt; und
die Leistungsversorgungsleitungen in den äußersten Verdrahtungsschichten der Laminate durch das leitende Durchgangsloch verbunden werden;
wobei die leitenden Durchkontakte für eine Zwischenverbindung der Signalverdrahtungsleitungen in den Verdrahtungsschichten verwendet werden und das leitende Durchgangslech für eine Leistungsverbindung verwendet wird.

3. Mehrschichtige Leiterplatte, wie in Anspruch 1 oder Anspruch 2 beansprucht, wobei das isolierende Substrat (10) ein Glas-Epoxydharzsubstrat ist.

4. Mehrschichtige Leiterplatte, wie in irgendeiner der vorhergehenden Ansprüche beansprucht, wobei die Signalverdrahtungsleitungen (40) in der äußersten Verdrahtungsschicht (36) strukturiert sind, um Anschlüsse für ein Verbinden von oberflächenmontierten Komponenten bereitzustellen.

5. Mehrschichtige Leiterplatte, wie in irgendeinem der vorhergehenden Ansprüche beansprucht, wobei die äußerste Verdrahtungsschicht (36) weiterhin eine Masseleitung (42) einschließt.

6. Verfahren zur Herstellung einer mehrschichtigen Leiterplatte, wie in irgendeinem der Ansprüche 1, 3, 4 oder 5 beansprucht, das die Schritte umfaßt:
(a) Präparieren des isolierenden Substrats (10), dessen beide Seiten mit Kupfer plattiert sind;
(b) Strukturieren der Kupferschicht (12) auf einer Seite des Substrats, um eine Verdrahtungsschicht, die Signalverdrahtungsleitungen (16) einschließt, zu bilden;
(c) Abscheiden einer isolierenden Schicht (18) auf der Verdrahtungsschicht;
(d) Bilden von Durchkontakten (20) in der isolierenden Schicht (18), um ausgesuchte Abschnitte der Signalverdrahtungsleitungen (16) freizulegen;
(e) Abscheiden einer Kupferschicht (22) auf der isolierenden Schicht, einschließlich den Durchkontakten;
(f) Strukturieren der abgeschiedenen Kupferschicht (22), um eine Verdrahtungsschicht, die Signalverdrahtungsleitungen (26) einschließt, zu bilden;
(g) Wiederholen, falls erforderlich, der Schritte (c) bis (f);
(h) Abscheiden einer isolierenden Schicht (28) auf der obersten Verdrahtungsschicht;
(i) Bilden von Durchkontakten in der isolierenden Schicht (28), die in Schritt (h) gebildet wird, um ausgesuchte Abschnitte der Signalverdrahtungsleitungen (26) in der obersten Verdrahtungsschicht freizulegen;
(j) Bilden des Durchgangsloches (32) an einer ausgesuchten Stelle der sich ergebenden Struktur;
(k) Abscheiden einer Kupferschicht (36) auf der gesamten Oberfläche der Struktur, einschließlich des Durchgangsloches (32); und
(l) Strukturieren der abgeschiedenen Kupferschicht (36), um auf der isolierenden Schicht, die in Schritt (h) gebildet wurde, die äußerste Verdrahtungsschicht einschließlich der Signalverdrahtungsleitungen (40) und der Leistungsversorgungsleitung (44) und auf der anderen Seite des Substrats die Leitungsschicht (14) einschließlich der Leistungsversorgungsleitung (46) zu bilden, wobei die Leistungsversorgungsleitungen (44, 46) in der äußersten Verdrahtungsschicht und die Leitungsschicht durch das Durchgangsloch (32) verbunden werden.

7. Verfahren zur Herstellung einer mehrschichtigen Leiterplatte, wie in irgendeinem der Ansprüche 2 bis 5 beansprucht, die Schritte umfassend:
(a) Präparieren des isolierenden Substrats (10), dessen beide Seiten mit Kupfer plattiert sind;
(b) Strukturieren der Kupferschichten (12, 14) auf beiden Seiten des Substrats, um Verdrahtungsschichten zu bilden, die Signalverdrahtungsleitungen (16, 16') einschließen;
(c) Abscheiden einer isolierenden Schicht (18, 18') auf jeder der Verdrahtungsschichten;
(d) Bilden von Durchkontakten (20, 20') in den isolierenden Schichten, um ausgesuchte Abschnitte der Signalverdrahtungsleitungen in den Verdrahtungsschichten freizulegen;
(e) Abscheiden einer Kupferschicht (22, 22') auf jeder der isolierenden Schichten, einschließlich den Durchkontakten;
(f) Strukturieren der abgeschiedenen Kupferschichten (22, 22'), um Verdrahtungsschichten, die Signalverdrahtungsleitungen (26, 26') einschließen, zu bilden;
(g) Wiederholen, falls erforderlich, der Schritte (c) bis (f) ;
(h) Abscheiden einer isolierenden Schicht (28, 28') auf jeder der obersten Verdrahtungsschichten;
(i) Bilden von Durchkontakten in den isolierenden Schichten, die in Schritt (h) gebildet wurden, um ausgesuchte Abschnitte der Signalverdrahtungsleitungen (26, 26') in den obersten Verdrahtungsschichten freizulegen;
(j) Bilden des Durchgangsloches (32) an einer ausgesuchten Stelle der sich ergebenden Struktur;
(k) Abscheiden einer Kupferschicht (36. 36') auf der gesamten Oberfläche der Struktur, einschließlich dem Durchgangsloch (32); und
(l) Strukturieren der abgeschiedenen Kupferschicht (36), um auf jeder Seite des Substrats die äußerste Verdrahtungsschicht, einschließlich der Signalverdrahtungsleitungen (40, 40') und der Leistungsversorgungsleitungen (44, 46) zu bilden, wobei die Leistungsversorgungsleitungen in den äußersten Verdrahtungsschichten durch das Durchgangsloch (32) verbunden werden.

8. Verfahren, wie in Anspruch 6 oder 7 beansprucht, wobei die isolierenden Schichten aus photoempfindlichem Harz hergestellt werden, und die Durchkontakte durch Belichten und Entwickeln der photoempfindlichen Schichten gebildet werden.

9. Verfahren, wie in irgendeinem der Ansprüche 6 bis 8 beansprucht, wobei die Abscheidung der Kupferschichten mittels stromlosem Plattieren durchgeführt wird.

## Revendications

1. Plaquette multicouches à circuits imprimés comprenant:
un substrat isolant (10);
une couche conductrice (14) sur l'un des côtés du dit substrats
une plaquette, sur l'autre côté du dit substrat, la dite plaquette comprenant des couches à câbles conducteurs (12, 22, 36) et au moins une couche isolante (18);
un trou débouchant conducteur (32) traversant le dit substrat (10) et la dite plaquette;
chacune des couches à câbles conducteurs (12, 22, 36) incluant des câbles conducteurs de signal (16, 26, 40) qui sont interconnectés par des passages conducteurs (24, 34) dans la dite couche isolante (ou les dites couches isolantes s'il y a lieu);
la dite couche conductrice (14) incluant un conducteur d'alimentation en énergie (46) et la couche à câbles conducteurs située le plus à l'extérieur (36) de la dite plaquette comporte des câbles conducteurs de signal (40) et un conducteur d'alimentation en énergie (44); et
les conducteurs de la puissance d'alimentation (46, 44) présents dans la dite couche conductrice (14) et dans la dite couche à câbles conducteurs située le plus à l'extérieur (36) étant interconnectés par le dit trou débouchant conducteur (32);
par quoi les dits passages conducteurs sont utilisés pour interconnecter les câbles conducteurs de signal dans les couches à câbles et le trou débouchant conducteur est utilisé pour un raccordement d'alimentation.

2. Plaquette multicouches à circuits imprimés comprenant:
un substrat isolant (10);
une plaquette sur chaque côté du dit substrat, chacune des dites plaquettes comprenant des couches de câblage et au moins une couche isolante;
un trou débouchant conducteur (32) traversant le dit substrat et les dites plaquettes;
chacune des dites couches de câblage (12, 22, 36) englobant des câbles conducteurs de signal (16, 26, 40) qui sont interconnectés par des passages conducteurs (24, 34) dans la dite couche isolante (ou dans les dites couches isolantes s'il y a lieu);
dans chacune des dites plaquettes, la couche de câblage située le plus à l'extérieur comprenant des câbles conducteurs de signaux (40, 40') et des conducteurs d'énergie d'alimentation (44, 46); et
les conducteurs d'alimentation en énergie présents dans les dites couches de câblage situées le plus à l'extérieur des dites plaquettes étant interconnectés par le dit trou débouchant conducteur;
par quoi les passages conducteurs sont utilisés pour interconnecter les câbles conducteurs de signal dans les couches à câbles et le trou débouchant conducteur est utilisé pour un raccordement d'alimentation.

3. Plaquette multicouches à circuits imprimés telle que revendiquée dans la revendication 1 ou dans la revendication 2 où le dit substrat isolant (10) est un substrat en verre-époxy.

4. Plaquette multicouches à circuits imprimés telle que revendiquée dans l'une quelconque des revendications précédentes, où les dits câbles conducteurs de signal (40) de la dite couche de câblage située le plus à l'extérieur (36) sont imprimés de manière à présenter des attaches pour la fixation des composants montés en surface.

5. Plaquette multicouches à circuits imprimés telle que revendiquée dans l'une quelconque des revendications précédentes, où la dite couche de câblage située le plus à l'extérieur (36) inclut en outre un conducteur de mise à la terre (42).

6. Méthode de fabrication d'une plaquette multicouches à circuits imprimés telle que revendiquée dans l'une quelconque des revendications 1, 3, 4 ou 5, comprenant les étapes suivantes:
a. préparation du substrat isolant (10), les deux surfaces étant plaquées de cuivre;
b. impression de la couche de cuivre (12) sur un des côtés du dit substrat pour former une couche de câblage englobant des câbles conducteurs de signal (16);
c. dépôt d'une couche isolante (18) sur la dite couche de câblage;
d. formation de passages (20) dans la dite couche isolante (18) pour exposer des parties de câbles conducteurs de signal (16) sélectionnées;
e. dépôt d'une couche de cuivre (22) sur la dite couche isolante, y compris dans les dits passages;
f. impression de la dite couche de cuivre déposé (22) pour former une couche de câblage incluant des câbles conducteurs de signal (26);
g. répétition des étapes (c) à (f), suivant les besoins;
h. dépôt d'une couche isolante (28) sur la couche de câblage supérieure;
i. formation de passages dans la couche isolante (28) réalisée lors de l'étape (h), afin d'exposer les parties choisies des câbles conducteurs de signal (26) de la dite couche de câblage supérieure;
j. formation du trou débouchant (32) à un emplacement choisi de la structure résultante;
k. dépôt d'une couche de cuivre (36) sur la totalité de la surface de la dite structure, y compris sur le dit trou débouchant (32); et
l. impression de la dite couche de cuivre déposé (36) pour former, sur la couche isolante formée lors de l'étape (h), la couche de câblage la plus externe englobant les câbles conducteurs de signal (40) et le conducteur de l'énergie d'alimentation (44) et, sur l'autre côté du dit substrat, la couche conductrice incluant le conducteur d'alimentation en énergie (46), les dits conducteurs de l'énergie d'alimentation (44, 46) situés dans la dite couche de câblage la plus externe et la dite couche conductrice étant interconnectés par le dit trou débouchant (32).

7. Méthode de fabrication d'une plaquette multicouches à circuits imprimés telle que revendiquée dans l'une quelconque des revendications 2 à 5, comprenant les étapes suivantes:
a. préparation du substrat isolant (10) en plaquant les deux surfaces de cuivre;
b. impression des couches de cuivre (12, 14) sur les deux côtés du dit substrat pour former des couches de câblage englobant les câbles conducteurs de signal (16, 16');
c. dépôt d'une couche isolante (18, 18') sur chacune des dites couches de câblage;
d. formation des passages (20, 20') dans les dites couches isolantes, afin d'exposer des portions choisies des dits câbles conducteurs de signal des dites couches de câblage;
e. dépôt d'une couche de cuivre (22, 22') sur chacune des dites couches isolantes, y compris sur les dits passages;
f. impression des couches de cuivre déposé (22, 22') pour former des couches de câblage incluant des câbles conducteurs de signal (26, 26');
g. répétition des dites étapes (c) à (f), suivant les besoins;
h. dépôt d'une couche isolante (28, 28') sur chacune des couches de câblage supérieures;
i. formation de passages dans les couches isolantes formées lors de l'étape (h), afin d'exposer des paries choisies des câbles conducteurs de signal (26, 26') dans les dites couches de câblage supérieures;
j. formation du trou débouchant (32) à un emplacement de la structure résultante choisi;
k. dépôt d'une couche de cuivre (36, 36') sur la totalité de la surface de la dite structure, y compris sur le dit trou débouchant (32); et
l. impression de la couche de cuivre déposée (36) pour former, sur chaque côté du dit substrat, la couche de câblage située le plus à l'extérieur englobant les câbles conducteurs de signal (40,40') et les conducteurs de l'énergie d'alimentation (44, 46), les dits conducteurs de l'énergie d'alimentation présents dans les dites couches de câblage situées le plus à l'extérieur étant interconnectés par le dit trou débouchant (32).

8. Méthode telle que revendiquée dans la revendication 6 ou dans la revendication 7, où les dites couches isolantes sont réalisées dans une résine photosensible et les dits passages sont réalisés en exposant et en développant les couches photosensibles.

9. Méthode telle que revendiquée dans l'une quelconque des revendication 6 à 8, où le dépôt des dites couches de cuivre est exécuté par dépôt de cuivre chimique.
